# EUROPÄISCHE PATENTSCHRIFT

(11) **EP 1 105 802 B1**
(45) Veröffentlichungstag und Bekanntmachung des Hinweises auf die Patenterteilung: **22.05.2002**
(21) Anmeldenummer: 99952423.4
(22) Anmeldetag: 17.08.1999
(51) Int. Cl.: G06F 11/20

(54) **VERFAHREN ZUR REPARATUR VON DEFEKTEN SPEICHERZELLEN EINES INTEGRIERTEN SPEICHERS**
METHOD FOR REPAIRING FAULTY STORAGE CELLS OF AN INTEGRATED MEMORY
PROCEDE DE REPARATION DE CELLULES DEFECTUEUSES D'UNE MEMOIRE INTEGREE

(30) Priorität: 26.08.1998 DE 19838861
(43) Veröffentlichungstag der Anmeldung: 13.06.2001
(73) Patentinhaber: Infineon Technologies AG, 81669 München (DE)
(72) Erfinder: SCHAMBERGER, Florian, D-83435 Bad Reichenhall (DE); SCHNEIDER, Helmut, D-80993 München (DE)
(74) Vertreter: Epping Hermann & Fischer
(86) Internationale Anmeldenummer: DE9902571
(87) Internationale Veröffentlichungsnummer: WO0013087

(56) Entgegenhaltungen:
- EP-A- 0 140 595
- DE-A- 19 736 250
- FR-A- 2 699 301
- DAY J R: "A FAULT-DRIVEN, COMPREHENSIVE REDUNDANCY ALGORITHM" IEEE DESIGN & TEST OF COMPUTERS,US,IEEE COMPUTERS SOCIETY. LOS ALAMITOS, Bd. 2, Nr. 3, 1. Juni 1985 (1985-06-01), Seiten 35-44, XP000744056 ISSN: 0740-7475
- BOSSE G P: "HIGH SPEED REDUNDANCY PROCESSOR" PROCEEDINGS OF THE INTERNATIONAL TEST CONFERENCE,US,SILVER SPRING, IEEE COMP. SOC. PRESS, Bd. SYMP. 1984, 1984, Seiten 282-286, XP000746695

## Beschreibung

Die Erfindung betrifft ein Verfahren zur Reparatur von defekten Speicherzellen eines integrierten Speichers.

In der US 5,410,687 A ist ein derartiges Verfahren beschrieben. Dort werden einzelne Speicherzellen eines Speichers getestet, die sich in Kreuzungspunkten von Zeilen und Spalten befinden. Für jede Spalte und jede Zeile weist der Speicher einen Fehlerzähler auf, in dem die für diese Spalte beziehungsweise Zeile detektierten Fehler aufsummiert werden. Nachdem alle Speicherzellen geprüft worden sind, erfolgt aufgrund der in den Fehlerzählern gespeicherten Informationen eine Reparatur defekter Speicherzellen mittels redundanter Spalten- und Zeilenleitungen. Das beschriebene Verfahren hat den Nachteil, daß die zu seiner Durchführung benötigten Fehlerzähler einen relativ großen Platzbedarf haben.

In der US 5,206,583 A ist eine integrierte Schaltung beschrieben, die auftrennbare Verbindungen (Fuses) für eine permanente Programmierung redundanter Elemente aufweist. Die integrierte Schaltung weist weiterhin den Fuses parallel geschaltete reversibel programmierbare Elemente in Form von Latches auf, die zu Testzwecken einer reversiblen Programmierung der redundanten Elemente dienen.

Der Erfindung liegt die Aufgabe zugrunde, ein Verfahren zur Reparatur von defekten Speicherzellen eines integrierten Speichers anzugeben, für das die notwendigen Hardware-Komponenten einen möglichst geringen Flächenbedarf aufweisen.

Diese Aufgabe wird mit einem Verfahren gemäß Anspruch 1 gelöst. Vorteilhafte Aus- und Weiterbildungen der Erfindung sind Gegenstand abhängiger Ansprüche.

Das erfindungsgemäße Verfahren sieht folgende Schritte vor:
- die Speicherzellen werden nacheinander geprüft,
- direkt im Anschluß an das Feststellen eines Defektes der jeweils geprüften Speicherzelle wird die betroffene Zeilenleitung oder die betroffene Spaltenleitung durch Programmierung einer der redundanten Leitungen ersetzt,
- nach erfolgter Programmierung einer bestimmten Anzahl der redundanten Leitungen wird bei Feststellen eines weiteren Defektes die Programmierung wenigstens einer redundanten Leitungen aufgehoben,
- und diese redundante Leitung wird zur Reparatur eines Defektes einer anderen Speicherzelle programmiert.

Die Spaltenleitungen können beispielsweise Bitleitungen und die Zeilenleitungen Wortleitungen des integrierten Speichers sein. Bei anderer Ausführungsbeispielen können auch die Spaltenleitungen Wortleitungen und die Zeilenleitungen Bitleitungen des Speichers sein.

Das Verfahren hat den Vorteil, daß (anders als bei der eingangs erwähnten US 5,410,687 A) keine Fehlerzähler für jede zu prüfende Spaltenleitung und Zeilenleitung notwendig sind, da die Reparatur eines Defektes jeweils unmittelbar nach seiner Feststellung erfolgt. Um trotzdem eine gewisse Optimierung der durchzuführenden Reparatur zu erreichen, folgt in Abhängigkeit der Anzahl der bereits zuvor programmierten redundanten Leitungen das Aufheben der Programmierung wenigstens einer der redundanten Leitungen, so daß anschließend mit dieser redundanten Leitung ein später festgestellter Defekt repariert werden kann.

Die reversible Programmierung der redundanten Leitungen kann beispielsweise mittels reversibel programmierbarer Elemente wie den in der US 5,206,583 A beschriebenen Latches erfolgen. Das erfindungsgemäße Reparaturverfahren zeichnet sich durch einen äußerst geringen Hardwareaufwand aus, so daß es sich besonders zur Implementierung eines Selbsttests und einer Selbstreparatur des zu reparierenden integrierten Speichers eignet. Das bedeutet, das alle erforderlichen Komponenten zur Durchführung des Reparaturverfahrens Bestandteile des integrierten Speichers sind beziehungsweise mit diesem auf derselben integrierten Schaltung angeordnet sind. Andererseits kann das erfindungsgemäße Verfahren selbstverständlich auch softwaremäßig implementiert oder auch durch einen externen Tester des integrierten Speichers durchgeführt werden.

Nach einer ersten Ausführungsform des Reparaturverfahrens werden die Speicherzellen zeilenweise auf Defekte geprüft und bei Feststellen eines Defektes der gerade geprüften Speicherzelle wird die betroffene Spaltenleitung durch eine redundante Spaltenleitung ersetzt, sofern die Anzahl der programmierten redundanten Spaltenleitungen dabei einen Grenzwert nicht überschreitet. Bei Überschreiten des Grenzwertes werden alle Programmierungen von redundanten Spaltenleitungen, die auf Grund von in der betroffenen Zeilenleitung festgestellten Defekten erfolgt sind, aufgehoben, und die betroffene Zeilenleitung wird durch eine der redundanten Zeilenleitungen ersetzt.

Bei dieser Ausführungsform erfolgt also eine Reparatur erkannter Defekte jeweils senkrecht zur Testrichtung. Es wird nämlich zeilenweise geprüft und zunächst spaltenweise ersetzt. Erst wenn die Anzahl der bereits verwendeten redundanten Spaltenleitungen den Grenzwert überschreitet, erfolgt eine zumindest teilweise Aufhebung der vorhergehenden Programmierungen. Allerdings werden nur die Programmierungen derjenigen redundanten Spaltenleitungen rückgängig gemacht, die aufgrund von in der betreffenden Zeilenleitung erkannter Defekte programmiert worden sind. Da die betroffene Zeilenleitung anschließend durch eine redundante Zeilenleitung ersetzt wird und die Programmierung von redundanten Spaltenleitungen, die aufgrund von in zuvor geprüften Zeilenleitungen erfolgt sind, nicht aufgehoben werden, werden bei ausreichendem Vorhandensein redundanter Leitungen auf die beschriebene Weise alle festgestellten Defekte innerhalb eines einzigen Prüfdurchlaufs der Speicherzellen repariert.

Nach einer Weiterbildung dieser Ausführungsform des Reparaturverfahrens wird der Grenzwert für die Anzahl der zu programmierenden redundanten Spaltenleitungen während der Überprüfung verändert. Dies ermöglicht eine Anpassung an die noch vorhandene Anzahl der noch nicht programmierten redundanten Spaltenleitungen.

Nach einer anderen Ausführungsform des Reparaturverfahrens werden die Speicherzellen, beginnend mit einer Startadresse, geprüft. Nachdem alle redundanten Leitungen programmiert worden sind, wird bei Feststellen eines weiteren Defektes die Programmierung einer der redundanten Leitungen aufgehoben. Die Speicherzellen werden anschließend, beginnend mit der Startadresse, erneut geprüft. Sofern dabei ein Defekt festgestellt wird, der adressenmäßig vor dem weiteren Defekt angeordnet ist, wird die Aufhebung der Programmierung der entsprechenden redundanten Leitung rückgängig gemacht. Das heißt, die entsprechende redundante Leitung wird zum Ersetzen derselben normalen Leitung programmiert, wie vor dem Aufheben ihrer Programmierung. Anschließend werden die drei vorhergehenden Verfahrensschritte bezüglich der Aufhebung der Programmierung einer anderen der redundanten Leitungen wiederholt. Sofern nach der Aufhebung der Programmierung einer der redundanten Leitungen während des daran anschließenden Prüfens der Speicherzellen kein Defekt festgestellt wird, der adressenmäßig vor dem weiteren Defekt angeordnet ist, wird dieser mit der durch die Aufhebung ihrer Programmierung frei gewordenen redundanten Leitung repariert.

Diese Ausführungsform der Erfindung ermöglicht die Aufhebung der Programmierung derjenigen redundanten Leitungen, die nur bereits festgestellte Defekte reparieren, die außerdem bereits durch andere redundante Leitungen behoben worden sind.

Daher bleiben nach Aufhebung der Programmierung der betreffenden redundanten Leitung diese Defekte repariert.

Die Erfindung wird im folgenden anhand der Figuren näher erläutert, die Ausführungsbeispiele darstellen.

Es zeigen:
- Figur 1: ein Flußdiagramm einer ersten Ausführungs-form des Reparaturverfahren,
- Figur 2: eine Ergänzung des Flußdiagramms aus Figur 1,
- Figur 3: ein Flußdiagramm für eine zweite Ausführungsform des Reparaturverfahrens
- Figuren 4 bis 10: ein Ausführungsbeispiel für die Durchführung des in Figur 3 dargestellten Reparaturverfahrens und
- Figuren 11 und 12: ein Ausführungsbeispiel für die Durchführung des in Figur 1 dargestellten Reparaturverfahrens.

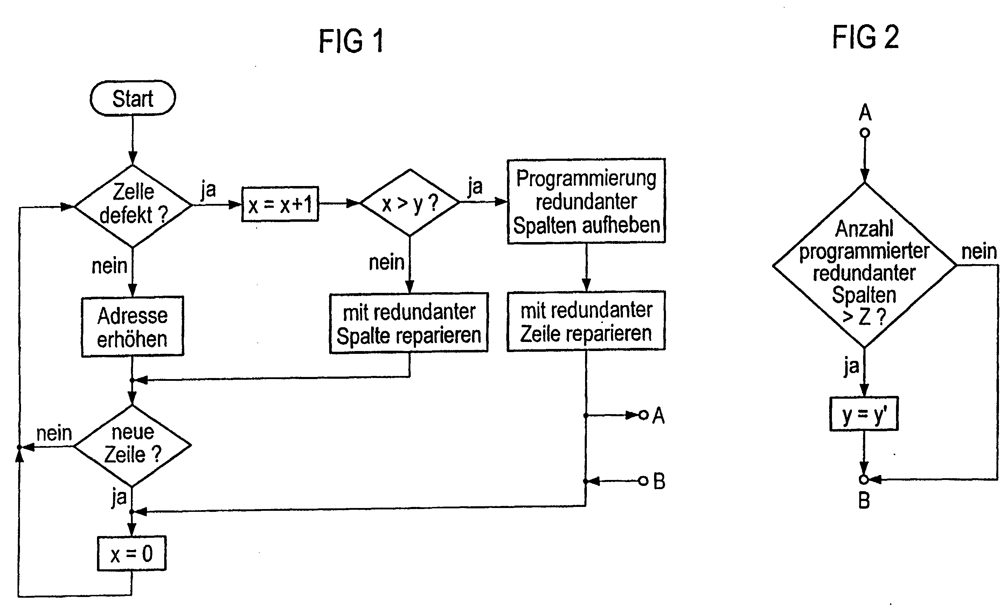

Gemäß Figur 1 werden die Speicherzellen des integrierten Speichers nacheinander geprüft. Zum Prüfen der jeweils nachfolgenden Speicherzelle wird die Adresse entsprechend erhöht. Jedes Mal zu Beginn des Prüfens einer neuen Zeilenleitung wird ein Zähler X auf Null gesetzt. Wird ein Defekt erkannt, wird der Zähler X um Eins erhöht und es erfolgt ein Vergleich des Standes des Zählers X mit einem Grenzwert Y. Der Grenzwert Y gilt für die Anzahl der maximal zugelassenen, für die Reparatur in der aktuellen Zeilenleitung programmierten Spaltenleitungen. Das Prüfen der Speicherzellen erfolgt nämlich zeilenweise, während bei Feststellen eines Defektes die Reparatur spaltenweise durchgeführt wird. Solange bei Feststellen eines Defekts der Zähler X den Grenzwert Y nicht überschreitet, wird der Defekt durch eine redundante Spaltenleitung behoben. Überschreitet der Zähler X jedoch den Grenzwert Y, wird die Programmierung derjenigen redundanten Spaltenleitungen aufgehoben, die zur Reparatur von in der aktuellen Zeilenleitung erkannten Defekten programmiert worden sind. Anschließend wird die aktuelle Zeilenleitung durch eine redundante Zeilenleitung repariert.

Besonders günstig ist es, wenn die ersetzende redundante Zeilenleitung nach dem Ersetzen selbst auf Fehler überprüft wird. Zu diesem Zweck wird das Reparaturverfahren mit der Überprüfung derjenigen Speicherzelle der redundanten Zeilenleitung fortgesetzt, die die niedrigste Spaltenadresse hat. Werden Fehler auf der redundanten Zeilenleitung entdeckt, erfolgt, wie zuvor, zunächst eine Reparatur über die redundanten Spaltenleitungen. Überschreitet deren Anzahl den zulässigen Grenzwert, wird ihre Programmierung aufgehoben und die redundante Zeilenleitung durch eine andere redundante Zeilenleitung ersetzt. Die Überprüfung der Speicherzellen einer programmierten redundanten Zeilenleitung kann selbstverständlich entfallen, wenn die redundanten Leitungen vor ihrer Programmierung geprüft worden sind und anschließend nur fehlerfreie redundante Leitungen für eine Reparatur herangezogen werden.

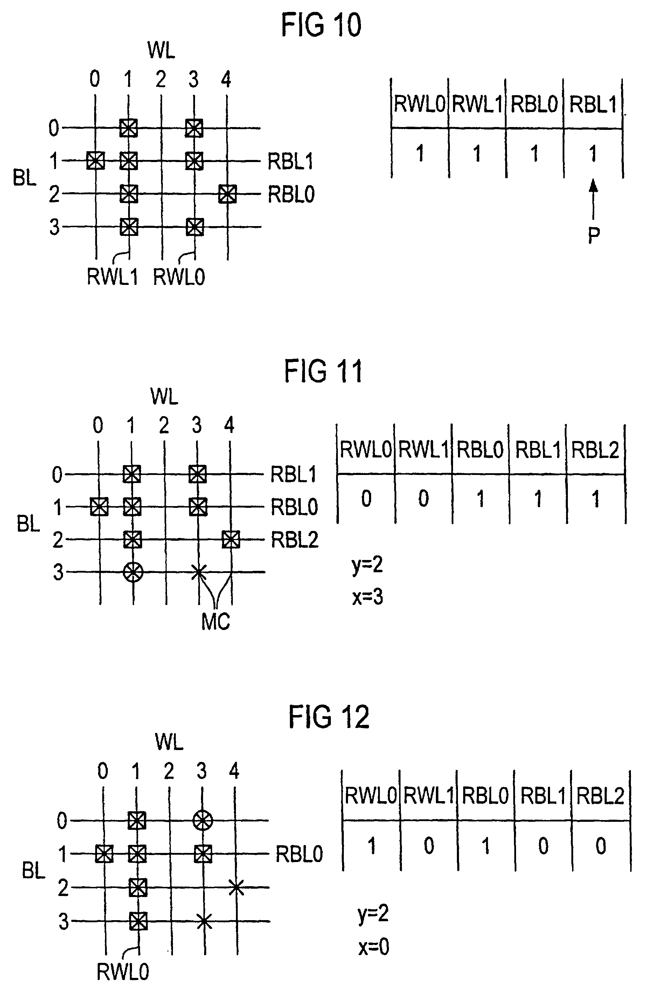

Ein Ausführungsbeispiel der ersten Ausführungsform des erfindungsgemäßen Reparaturverfahrens soll im folgenden anhand der Figuren 11 und 12 beschrieben werden. In Figur 11 ist im linken Teil ein Speicherzellenfeld des integrierten Speichers und im rechten Teil eine Übersicht über die redundanten Leitungen dargestellt. Die Figuren 11 und 12 sowie 4 bis 10 verwenden im wesentlichen dieselbe Darstellungsweise, weshalb auf diese nur einmal eingegangen wird. Die Speicherzellen MC des integrierten Speichers sind in Kreuzungspunkten von Bitleitungen BL und Wortleitungen WL angeordnet. Die Bitleitungen BL sind von 0 bis 3 und die Wortleitungen WL von 0 bis 4 durchnumeriert. Defekte Speicherzellen MC sind durch Kreuze markiert. Bereits durch redundante Leitungen reparierte Speicherzellen MC sind durch Quadrate markiert. Ein Kreis markiert den aktuellen, also soeben erst festgestellten Defekt einer der Speicherzellen MC. Im rechten Teil der Figur 11 ist eine Tabelle dargestellt, die zur Veranschaulichung alle zur Verfügung stehenden redundanten Leitungen des Speichers enthält. Beim anhand der Figuren 11 und 12 erläuterten Ausführungsbeispiel weist der Speicher zwei redundante Wortleitungen RWL0, RWL1 und drei redundante Bitleitungen RBL0, RBL1, RBL2 auf. Die Tabelle gibt an, welche dieser redundanten Leitungen bereits zum Ersetzen einer der normalen Leitungen BL, WL programmiert worden ist. Eine Null bedeutet dabei, das die zugehörige redundante Leitung noch nicht programmiert worden ist, und eine Eins bedeutet, daß bereits eine Programmierung erfolgt ist.

Dem linken Teil der Figur 11 ist auch zu entnehmen, auf welche Weise die defekten Speicherzellen MC repariert worden sind. Rechts des Speicherzellenfeldes sind nämlich die zum Ersetzen der jeweiligen normalen Bitleitungen BL programmierten redundanten Bitleitungen RBLi eingetragen und unterhalb des Speicherzellenfeldes die zum Ersetzen der normalen Wortleitungen programmierten redundanten Wortleitungen RWLi. Im vorliegenden Fall erfolgte bereits vor dem in Figur 11 dargestellten Zustand ein sequentielles Prüfen der Speicherzellen MC, beginnend mit der Speicherzellenadresse 0,0 (das heißt Wortleitung WL0 und Bitleitung BL0), und zwar in Richtung der Wortleitungen WL. Die Speicherzelle 0,0 weist keinen Defekt auf. Anschließend wurde die Speicherzelle 0,1 geprüft (Wortleitung WL0, Bitleitung BL1), wobei ein Defekt festgestellt wurde. Dieser Defekt wurde dadurch repariert, daß die Bitleitung 1 durch die redundante Bitleitung RBL0 ersetzt wurde. Anschließend wurden die Speicherzellen weiter getestet, wobei beim Beginn der nächsten Wortleitung WL1 der Fehlerzähler X auf 0 rückgesetzt wurde. Die defekte Speicherzelle 1,0 auf der Wortleitung WL1 wurde durch die redundante Bitleitung RBL1 repariert und der Fehlerzähler X auf den Wert 1 erhöht. Da die Bitleitung BL1 bereits durch die redundante Bitleitung RBL0 ersetzt worden ist, ist der nächste festgestellte Fehler derjenige mit der Adresse 1,2. Dieser wird mit der redundanten Bitleitung RBL2 repariert. Der Fehlerzähler X wird auf 2 erhöht. Als nächstes wird der Defekt der Speicherzelle 1,3 festgestellt. Dieser Zustand ist in Figur 11 dargestellt. Dieser Defekt wird nicht mit einer redundanten Bitleitung repariert, da der Fehlerzähler X auf Drei erhöht wird und damit den Grenzwert Y, der ebenfalls den Wert Zwei hat, überschritten hat. Als Folge dessen wird die Programmierung der redundanten Bitleitungen RBL1 und RBL2, die aufgrund der in der aktuellen Wortleitung WL1 festgestellten Defekte an den Adressen 1,0 und 1,2 festgestellt worden sind, aufgehoben. Die Programmierung der redundanten Bitleitung RBL0, die die normale Bitleitung BL1 ersetzt, wird dagegen nicht aufgehoben, da sie nicht aufgrund eines in der aktuellen Wortleitung WL1 detektierten Defektes erfolgte. Ihre Programmierung erfolgte aufgrund des in der Wortleitung WL0 festgestellten Defektes mit der Adresse 0,1. Anschließend wird die normale Wortleitung WL1 durch die redundante Wortleitung RWL0 ersetzt.

Figur 12 zeigt diesen Zustand des integrierten Speichers. Der Grenzwert Y wird wiederum auf den Wert 2 festgesetzt, da erneut zwei der redundanten Bitleitungen RBLi für eine Programmierung zur Verfügung stehen. Dies sind die redundanten Bitleitungen RBL1 und RBL2, deren Programmierung, wie soeben beschrieben, aufgehoben worden ist. Die Speicherzellen werden fortlaufend geprüft, so daß als nächstes der Defekt mit der Adresse 3,0 festgestellt wird. Dieser wird wiederum mit einer der redundanten Bitleitungen RBLi repariert. Das Reparaturverfahren wird auf analoge Weise fortgesetzt, wobei die Programmierung einiger der redundanten Bitleitungen immer dann aufgehoben wird, wenn der Stand des Zählers X den Grenzwert Y überschreitet.

Ändert sich die Zahl der zur Verfügung stehenden, noch nicht programmierten redundanten Bitleitungen RBLi, wird zu Beginn des Prüfens der nächsten Wortleitung WLi der Grenzwert Y neu festgesetzt. Figur 2 ist eine Ergänzung des Flußdiagramms aus Figur 1 an der mit A und B bezeichneten Stelle zu entnehmen, wonach der Grenzwert Y beispielsweise dann angepaßt wird, wenn die Anzahl der bereits programmierten redundanten Spaltenleitungen einen Wert Z überschreitet. In diesem Fall steht nur noch eine relativ geringe Anzahl von redundanten Spaltenleitungen für eine Programmierung zur Verfügung, so daß der Grenzwert Y auf einen Wert Y' erniedrigt werden muß.

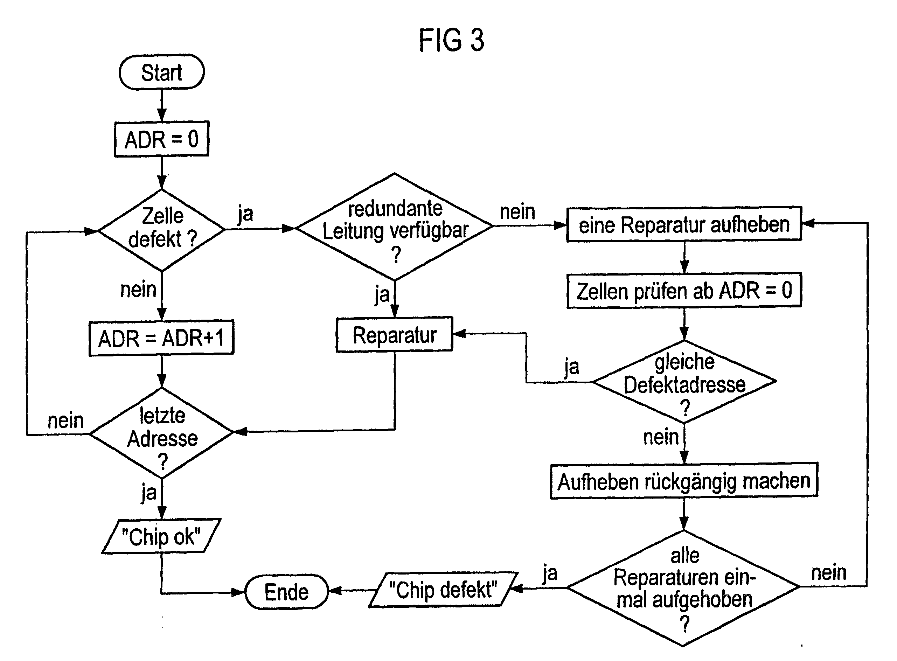

Figur 3 zeigt das Flußdiagramm für eine zweite Ausführungsform des erfindungsgemäßen Reparaturverfahrens. Die Speicherzellen werden, beginnend mit einer Adresse ADR=0 sequentiell geprüft. So lange kein Fehler festgestellt wird, wird die Adresse fortlaufend inkrementiert. Wenn die letzte Adresse erreicht worden ist und kein Defekt als nicht reparierbar übrig bleibt, gilt die integrierte Schaltung als repariert und das Reparaturverfahren wird beendet. Sobald eine defekte Speicherzelle festgestellt worden ist, erfolgt, solange noch eine redundante Leitung für eine Programmierung zur Verfügung steht, eine Reparatur des Defekts durch Ersetzen der betroffenen Zeilenleitung oder der betroffenen Spaltenleitung durch eine entsprechende redundante Leitung. Sind jedoch bereits alle redundanten Leitungen programmiert worden, wird die Programmierung einer der redundanten Leitungen aufgehoben, so daß wieder die ursprüngliche, normale Spalten- beziehungsweise Zeilenleitung adressiert wird. Anschließend werden alle Speicherzellen, beginnend mit der Startadresse ADR=0, erneut sequentiell geprüft. Wird dabei kein Defekt festgestellt, der adressenmäßig vor dem zuletzt festgestellten Defekt liegt, steht fest, daß die durch die redundante Leitung, deren Programmierung aufgehoben worden ist, reparierten Defekte auch durch andere redundante Leitungen (also mehrfach) repariert worden sind. Daher kann die freigewordene redundante Leitung zur Reparatur des zuletzt festgestellten Defektes verwendet werden. Wird jedoch ein Defekt mit niedriger Adresse festgestellt, als diejenige des zuletzt festgestellten Defektes, wird die Aufhebung der Programmierung der betroffenen redundanten Leitung rückgängig gemacht. Das bedeutet, sie wird genauso erneut programmiert, wie es vor dem Aufheben ihrer Programmierung der Fall war. Diese redundante Leitung kann also nicht für eine Reparatur des aktuellen Defektes verwendet werden. Statt dessen wird die Programmierung einer anderen der redundanten Leitungen aufgehoben und die Zellen werden erneut geprüft. Dieses Verfahren wird solange wiederholt, bis die Aufhebung der Programmierung einer der redundanten Leitung zum Erfolg führt oder bis die Programmierung aller redundanten Leitungen nacheinander aufgehoben worden ist, ohne das der aktuelle Defekt repariert werden konnte. Im letztgenannten Fall wird der Chip als defekt gekennzeichnet und das Reparaturverfahren beendet.

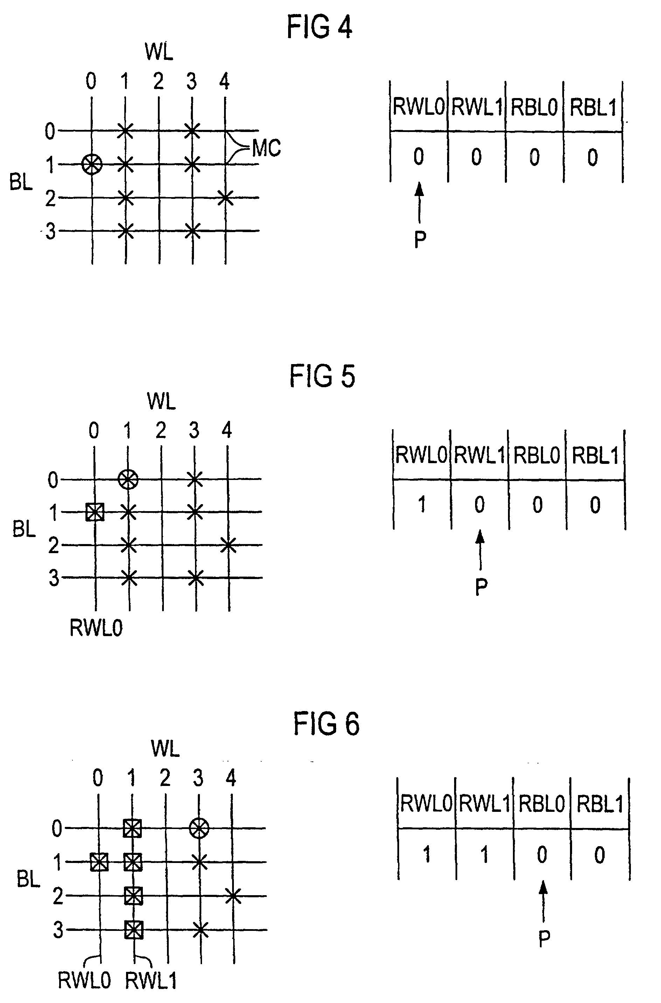

Im folgenden wird anhand der Figuren 4 bis 10 ein konkretes Ausführungsbeispiel des in Figur 3 dargestellten Reparaturverfahrens geschildert. Bei diesem Ausführungsbeispiel verfügt der integrierte Speicher über zwei redundante Wortleitungen RWL0, RWL1 und zwei redundante Bitleitungen RBL0, RBL1. Defekte Speicherzellen MC sind wiederum durch Kreuze im Speicherzellenfeld gekennzeichnet. Der Kreis kennzeichnet den aktuellen festgestellten Defekt. Die Reparatur erkannter Defekte erfolgt bei diesem Ausführungsbeispiel durch Programmierung der redundanten Leitungen in der in der Tabelle im rechten Teil der Figuren dargestellten Reihenfolge. Zur Reparatur des ersten Defektes mit Adresse 0,1 (Wortleitung WL0, Bitleitung BL1) wird daher die redundante Wortleitung RWL0 verwendet. Ein Zeiger P zeigt auf die jeweils als nächstes zu verwendende redundante Leitung.

Figur 5 zeigt den integrierten Speicher, nachdem die Wortleitung WL0 adressenmäßig durch die redundante Wortleitung RBL0 ersetzt worden ist. Die erfolgte Programmierung der redundanten Wortleitung RWL0 ist in der Tabelle durch eine 1 gekennzeichnet. Der Zeiger P zeigt auf die als nächstes zu programmierende redundante Leitung RWL1. Das Prüfen der Speicherzellen wird sequentiell fortgesetzt und als nächstes der Defekt der Speicherzelle 1,0 festgestellt. Gemäß Figur 6 wird dieser Defekt durch Programmierung der redundanten Wortleitung RWL1 repariert. Automatisch werden dabei auch die anderen Defekte auf der Wortleitung WL1 repariert, ohne daß diese geprüft werden müssen. Hierbei wird vorausgesetzt, daß die programmierten redundanten Leitungen jeweils fehlerfrei sind. Dies kann durch einen vor ihrer Programmierung durchgeführten Test festgestellt werden. Es werden nur die dabei als fehlerfrei festgestellten redundanten Leitungen für eine Reparatur herangezogen.

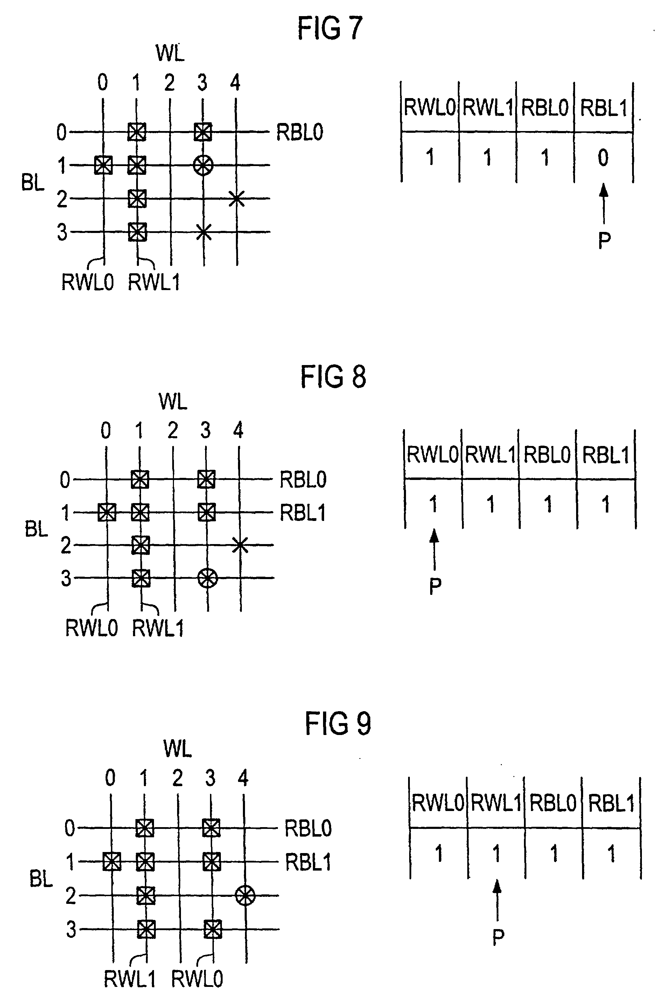

Da die nächste Wortleitung WL2 keinen Defekt aufweist, ist der nächste festgestellte Defekt derjenige mit der Adresse 3,0. Der Zeiger P zeigt inzwischen auf die dritte redundante Leitung RBL0, so daß der aktuelle Defekt durch die redundante Bitleitung RBL0 ersetzt wird. Dies ist in Figur 7 dargestellt. Gemäß Figur 8 wird der nächste Defekt mit der Adresse 3,1 durch die redundante Bitleitung RBL1 ersetzt.

Der nächste festgestellte Defekt mit der Adresse 3,3 kann nun nicht mehr ohne weiteres repariert werden, da bereits alle redundanten Leitungen programmiert worden sind und der Zeiger P erneut auf die erste redundante Leitung RWL0 zeigt. Bei diesem Ausführungsbeispiel wird nun die Programmierung derjenigen redundanten Leitung, auf die der Zeiger P zeigt (dies ist die als erste programmierte redundante Leitung RBL0), aufgehoben. Da der einzige bislang durch die redundante Wortleitung RWL0 reparierte Defekt derjenige mit der Adresse 0,1 ist, und dieser Defekt außerdem auch durch die Programmierung der redundanten Bitleitung RBL1 behoben worden ist, wird beim anschließenden Test aller Speicherzellen kein Defekt festgestellt, der adressenmäßig vor dem aktuellen Defekt mit der Adresse 3,3 angeordnet ist. Daher wird die durch die Aufhebung ihrer Programmierung frei gewordene redundante Wortleitung RWL0 zur Reparatur des Defekts der Speicherzelle 3,3 verwendet. Dieser Zustand ist in Figur 9 dargestellt. Der Zeiger P rückt zur nächsten redundanten Leitung vor. Der Speichertest wird mit den noch nicht geprüften Speicherzellen MC fortgesetzt und es wird der Defekt mit Adresse 4,2 festgestellt. Anschließend wird die Programmierung der redundanten Wortleitung RWL1, auf die der Zeiger P zeigt, rückgängig gemacht. Die Speicherzellen werden, beginnend mit der Adresse 0,0 erneut geprüft, wobei der Defekt mit der Adresse 1,2 als erstes festgestellt wird. Dessen Adresse ist kleiner als die Adresse 4,2 des aktuellen Defekts. Daher wird die Aufhebung der Programmierung der redundanten Wortleitung RWL1 wieder rückgängig gemacht.

Der Zeiger rückt auf die nächste redundante Leitung RBL0 vor (Figur 10). Da der aktuelle Defekt mit der Adresse 4,2 noch immer nicht repariert ist, wird nun die Programmierung dieser redundanten Leitung RBL0 aufgehoben. Die Speicherzellen werden, beginnend mit der Startadresse 0,0 erneut getestet. Dabei wird kein Defekt festgestellt, der vor dem aktuellen Defekt mit der Adresse 4,2 liegt. Dies liegt daran, daß die Defekte mit den Adressen 1,0 und 3,0 bereits durch die redundanten Wortleitungen RBL1 und RWL0 repariert worden sind. Somit kann die frei gewordene redundante Bitleitung RBL0 zur Reparatur des aktuellen Defektes programmiert werden. Dieser Zustand ist in Figur 10 gezeigt. Der Zeiger P rückt auf die nächste programmierte redundante Leitung RBL1 vor. Als letztes wird noch die Speicherzelle mit der Adresse 4,3 geprüft, die keinen Defekt aufweist. Daher wird das Reparaturverfahren mit einem vollständig reparierten integrierten Speicher abgeschlossen.

## Patentansprüche

1. Verfahren zur Reparatur von defekten Speicherzellen (MC) eines integrierten Speichers, die in Kreuzungspunkten von Zeilenleitungen (WL) und Spaltenleitungen (BL) angeordnet sind, durch eine reversible Programmierung von redundanten Zeilenleitungen (RWL) und redundanten Spaltenleitungen (RBL) mit folgenden Schritten:
- die Speicherzellen (MC) werden nacheinander geprüft,
- direkt im Anschluß an das Feststellen eines Defektes der jeweils geprüften Speicherzelle wird die betroffene Zeilenleitung (WL) oder die betroffene Spaltenleitung (BL) durch Programmierung einer der redundanten Leitungen (RWL, RBL) ersetzt,
- nach erfolgter Programmierung einer bestimmten Anzahl der redundanten Leitungen (RWL, RBL) wird bei Feststellen eines weiteren Defektes die Programmierung wenigstens einer der redundanten Leitungen aufgehoben,
- und diese redundante Leitung (RWL, RBL) wird zur Reparatur eines Defektes einer anderen Speicherzelle (MC) programmiert.

2. Verfahren nach Anspruch 1 mit folgenden Schritten:
- die Speicherzellen (MC) werden zeilenweise auf Defekte geprüft,
- bei Feststellen eines Defektes der gerade geprüften Speicherzelle (MC) wird die betroffene Spaltenleitung (BL) durch eine der redundanten Spaltenleitungen (RBL) ersetzt, sofern die Anzahl (X) der programmierten redundanten Spaltenleitungen RBL dabei einen Grenzwert (Y) nicht überschreitet,
- bei Überschreiten des Grenzwertes (Y) werden alle Programmierungen von redundanten Spaltenleitungen (RBL), die aufgrund von in der betroffenen Zeilenleitung (WL) festgestellten Defekten erfolgt sind, aufgehoben,
- und die betroffene Zeilenleitung (WL) wird durch eine der redundanten Zeilenleitungen (RWL) ersetzt.

3. Verfahren nach Anspruch 2,
bei dem der Grenzwert (Y) während der Überprüfung verändert wird.

4. Verfahren nach Anspruch 1 mit folgenden Schritten:
- die Speicherzellen (MC) werden, beginnend mit einer Startadresse, geprüft,
- nachdem alle redundanten Leitungen (RWL, RBL) programmiert worden sind, wird bei Feststellen eines weiteren Defektes die Programmierung einer der redundanten Leitungen aufgehoben,
- die Speicherzellen (MC) werden anschließend, beginnend mit der Startadresse, erneut geprüft,
- sofern dabei ein Defekt festgestellt wird, der adressenmäßig vor dem weiteren Defekt angeordnet ist, wird die Aufhebung der Programmierung der entsprechenden redundanten Leitung (RWL, RBL) rückgängig gemacht,
- anschließend werden die drei vorhergehenden Verfahrensschritte bezüglich der Aufhebung der Programmierung einer anderen der redundanten Leitungen (RWL, RBL) wiederholt,
- sofern nach der Aufhebung der Programmierung einer der redundanten Leitungen (RWL, RBL) während des daran anschließenden Prüfens der Speicherzellen (MC) kein Defekt festgestellt wird, der adressenmäßig vor dem weiteren Defekt angeordnet ist, wird dieser mit der durch die Aufhebung ihrer Programmierung frei gewordenen redundanten Leitung repariert.

5. Verfahren nach Anspruch 4,
bei dem der Speicher als nicht reparierbar **gekennzeichnet** wird, wenn nach Feststellen des weiteren Defektes die nacheinander durchgeführte Aufhebung der Programmierung aller redundanten Leitungen (RBL, RWL) keine Reparatur aller bislang erkannten Defekte ermöglicht.

## Claims

1. Method for repairing defective memory cells (MC) of an integrated memory, which are arranged at cross points of row lines (WL) and column lines (BL), by means of reversible programming of redundant row lines (RWL) and redundant column lines (RBL), comprising the following steps:
- the memory cells (MC) are successively tested,
- immediately following the detection of a defect of the memory cell tested in each case, the row line (WL) affected or the column line (BL) affected is replaced by programming one of the redundant lines (RWL, RBL),
- after a certain number of the redundant lines (RWL, RBL) have been programmed, programming of at least one of the redundant lines is cancelled if a further defect is found,
- and this redundant line (RWL, RBL) is programmed for repairing a defect of another memory cell (MC).

2. Method according to Claim 1, comprising the following steps:
- the memory cells (MC) are tested for defects row by row,
- when a defect of the memory cell (MC) just tested is found, the column line (BL) affected is replaced by one of the redundant column lines (RBL) if the number (X) of the programmed redundant column lines (RBL) does not exceed a limit value (Y),
- if the limit value (Y) is exceeded, any programming of redundant column lines (RBL) which has taken place due to defects having been found in the row line (WL) affected is cancelled,
- and the row line (WL) affected is replaced by one of the redundant row lines (RWL).

3. Method according to Claim 2, in which the limit value (Y) is changed during the checking.

4. Method according to Claim 1, comprising the following steps:
- the memory cells (MC) are tested, beginning at a start address,
- once all redundant lines (RWL, RBL) have been programmed, the programming of one of the redundant lines is cancelled if another defect is found,
- the memory cells (MC) are then tested again, beginning at the start address,
- if, during this process, a defect is found, the address of which is arranged before the further defect, the cancellation of the programming of the corresponding redundant line (RWL, RBL) is reversed,
- after that, the three preceding method steps with respect to the cancellation of the programming of another one of the redundant lines (RWL, RBL) are repeated,
- if, after the cancellation of the programming of one of the redundant lines (RWL, RBL), during the subsequent testing of the memory cells (MC), no defect is found, the address of which is arranged before the further defect, the latter is repaired by means of the redundant line which has become available due to the cancellation of its programming.

5. Method according to Claim 4, in which the memory is marked as unrepairable if, after the further defect has been found, the successive cancellation of the programming of all redundant lines (RBL, RWL) does not provide for any repair of all defects hitherto detected.

## Revendications

1. Procédé pour la réparation de cellules de mémoire (MC) défectueuses d'une mémoire intégrée, lesquelles cellules de mémoire sont disposées aux points d'intersection de conducteurs de ligne (WL) et de conducteurs de colonne (BL), par une programmation réversible de conducteurs de ligne redondants (RWL) et de conducteurs de colonne redondants (RBL), comprenant les étapes suivantes
- on teste les cellules de mémoire (MC) les unes après les autres,
- immédiatement après la détection d'un défaut de la cellule de mémoire respectivement testée, on remplace le conducteur de ligne concerné (WL) ou le conducteur de colonne concerné (BL) en programmant l'un des conducteurs redondants (RWL, RBL),
- après avoir effectué la programmation d'un certain nombre des conducteurs redondants (RWL, RBL), si on détecte un autre défaut, on annule la programmation d'au moins un conducteur redondant,
- et on programme ce conducteur redondant (RWL, RBL) pour la réparation d'un défaut d'une autre cellule de mémoire (MC).

2. Procédé selon la revendication 1 avec les étapes suivantes :
- on teste les cellules de mémoire (MC) ligne par ligne à la recherche d'éventuels défauts,
- lorsqu'on détecte un défaut de la cellule de mémoire (MC) qui vient d'être testée, on remplace le conducteur de colonne concerné (BL) par l'un des conducteurs de colonne (RBL) dans la mesure où le nombre (X) des conducteurs de colonne redondants programmés (RBL) ne dépasse pas alors une valeur limite (Y),
- lors d'un dépassement de la valeur limite (Y), on annule toutes les programmations de conducteurs de colonne redondants (RBL) qui ont été effectuées en raison de défauts détectés dans le conducteur de ligne concerné (WL),
- et on remplace le conducteur de ligne concerné (WL) par l'un des conducteurs de ligne redondants (RWL).

3. Procédé selon la revendication 2,
dans lequel on modifie la valeur limite (Y) pendant le test.

4. Procédé selon la revendication 1 avec les étapes suivantes:
- on teste les cellules de mémoire (MC) en commençant à une adresse de début,
- après avoir programmé tous les conducteurs redondants (RWL, RBL), si on détecte un autre défaut, on annule la programmation d'un des conducteurs redondants,
- puis on teste à nouveau les cellules de mémoire (MC) en commençant à l'adresse de début,
- dans la mesure où l'on détecte alors un défaut qui est disposé quant à son adresse avant l'autre défaut, on annule l'annulation de la programmation du conducteur redondant correspondant (RWL, RBL),
- on répète ensuite les trois étapes de procédé précédentes par rapport à l'annulation de la programmation d'un autre des conducteurs redondants (RWL, RBL),
- dans la mesure où l'on ne détecte après l'annulation de la programmation d'un des conducteurs redondants (RWL, RBL) pendant le test consécutif des cellules de mémoire (MC) aucun défaut qui se trouve quant à son adresse avant l'autre défaut, on répare ce dernier avec le conducteur redondant libéré par l'annulation de sa programmation.

5. Procédé selon la revendication 4,
dans lequel on **caractérise** la mémoire comme non réparable si, après la détection de l'autre défaut, les annulations effectuées successivement des programmations de tous les conducteurs redondants (RBL, RWL) ne permettent pas de réparer tous les défauts détectés jusqu'ici.
